# EUROPEAN PATENT APPLICATION

(11) **EP 2 246 954 A1**
(43) Date of publication of application: **03.11.2010**
(21) Application number: 09159193.3
(22) Date of filing: 30.04.2009
(51) Int. Cl.: H02H 3/00

(54) **Intelligent electronic device with a detachable memory module for substation automation**

(71) Applicant: ABB Research Ltd, 8050 Zürich (CH)
(72) Inventor: Frei, Christian, CH-5442 Fislisbach (CH); Tournier, Jean-Charles, CH-5404 Baden (CH); Werner, Thomas, CH-5404 Baden (CH)
(74) Representative: ABB Patent Attorneys

(57) **Abstract**

An Intelligent Electronic Device (1) for Substation Automation or process control comprises a dedicated memory module (3, 3') for storing configuration information associated with the Intelligent Electronic Device (1), and a connector (4) for attaching and detaching and thereby connecting and disconnecting electrically the memory module (3, 3') to and from at least one printed circuit board (21, 22, 23) of the Intelligent Electronic Device (1). The dedicated memory module (3, 3') and the connector (4) make it possible to shorten outage time because recovering from a device failure can be limited to physical replacement of components without the need of further activities related to configuration of the Intelligent Electronic Device (1), because the current configuration information always resides in the memory module (3, 3').

## Description

### FIELD OF THE INVENTION

The present invention relates to an Intelligent Electronic Device for Substation Automation or process control. Specifically, the invention relates to device specific configuration of an Intelligent Electronic Device for Substation Automation or process control, e.g. in an electric power system.

### BACKGROUND OF THE INVENTION

In an electric power system, specifically in high and medium-voltage power networks, substations include primary devices such as electrical cables, lines, bus bars, switches, power transformers and instrument transformers, which are generally arranged in switch yards and/or bays. These primary devices are operated in an automated way via a Substation Automation system. The Substation Automation system comprises secondary devices, including Intelligent Electronic Devices (IED), responsible for protection, control and monitoring of the primary devices.

IEDs for Substation Automation or process control are embedded devices, typically comprising a multitude of electrical boards, i.e. printed circuit boards such as a power module, a Central Processing Unit (CPU) module, communication board, binary I/O and analog input modules. The boards are connected through a backplane bus with each other. Optionally, a human machine interface including a display and a data entry means such as a keyboard or separate keys enable local operation and configuration of the device, as well as displaying information, such as local alarms and measurement values.

Typically the CPU module includes flash memory for storing, among others, the device configuration.

Modem IEDs are connected through an Ethernet-based station bus with each other on which system-wide information is exchanged, e.g. according to the IEC61850 protocol: status updates of switches and breakers, interlocking information, breaker and switch commands, and/or information reports. The setup of the IED participating in the station communication is configured during the system-engineering phase, and the IED's s specific configuration is extracted.

Typically, the device configuration is generated with the help of engineering tools, which hold the system perspective (i.e. the various IEDs exchanging information with each other). From that level, a specific device configuration is created. In addition to the system configuration, each device configuration may be extended with some local settings. For example, the local display, e.g. an LCD panel and/or LEDs, and data entry means, e.g. a keyboard or separate keys, of the human machine interface can be configured (freely) according to customer specification. For example, a status LED is typically assigned ("wired logically") to specific events occurring on the respective IED.

Based on the system configuration and the IED's specific device functionality, a device configuration is generated, which is nowadays mostly available in the form of an XML file.

This configuration file, being specific for an associated IED, is typically kept in a database stored with the OEM responsible for the commissioning of a secondary substation system. The initial configuration (file) is loaded onto an IED during the commissioning phase.

Malfunctioning of a device typically leads to a repair or replacement of the CPU module/board, another printed circuit board, or of the complete IED, with a spare unit. However, as the IED's configuration is stored in some persistent storage on the CPU board, the configuration needs to be reloaded onto the new device (IED). This is usually achieved through a communication connection from a PC/Laptop to the IED while a maintenance engineer is onsite. The configuration reloading process also requires that the configuration which was set up on the failing IED and the configuration which is stored in a commissioning database (to which the engineer has access) are still in sync and have not changed between the time the engineering has been done and the time of the device failure.

Thus, upon device failure, there are a number of steps which need to be performed in order to replace a failing device and setting up a spare device:
- Failing device (complete IED or faulty module) is replaced with a spare unit of same model,
- Original configuration needs to be located at the responsible OEM and loaded onto an engineering laptop,
- Tests need to be run in order to make sure that the configuration was still in sync (i.e. the configuration information stored with the OEM is the same as the one that was running on the failing IED), and
- A maintenance engineer has to go to the station and load the configuration onto
   the IED.

As can be seen from the number of process steps involved, replacing a failing IED is time consuming and error prone, as
- Configuration loaded on the IED is not reused/replicated onto the new IED, but kept separated in a configuration database,
- Configuration database might not be accessible and/or not all changes are replicated back to the configuration, and
- Long expected lifetime might make it difficult to load configurations (outdated Operating System, old applications).

### DESCRIPTION OF THE INVENTION

It is therefore an objective of the present invention to provide an Intelligent Electronic Device (IED) for Substation Automation or process control, e.g. in an electric power system, the IED making possible efficient maintenance of the device configuration in case of a device failure. Particularly, it is a an objective of the present invention to provide an IED requiring less time and interaction with external IT systems than prior art systems for maintaining the device configuration in case of a device failure.

These objectives are achieved by an IED for Substation Automation or process control according to claim 1. Further preferred embodiments are evident from the dependent claims.

According to the present invention, the above-mentioned objects are particularly achieved in that, an Intelligent Electronic Device (IED) for Substation Automation or process control, e.g. in an electric power system, is further provided with a dedicated memory module for storing configuration information associated with the IED, and a connector (connection element) for connecting and disconnecting the memory module to and from at least one printed circuit board of the IED. For example, the configuration information includes a name assigned to the IED, one or more addressing elements assigned to the IED, and/or configuration data related to a human machine interface of the IED. For example, the circuit board comprises a CPU configured to read the configuration information from the memory module. For example, the memory module comprises flash memory.

Providing the dedicated memory module and the connector prevents outdated or unsynchronized configuration information from being stored in an IED after a device failure, because the "working" configuration always resides with the IED or its associated memory module, respectively. Furthermore, outage time is shortened because recovering from a device failure can be limited to physical replacement of components without the need of further activities regarding device configuration.

Preferably, the connector is configured to attach and detach and thereby connect and disconnect electrically the memory module to and from the at least one printed circuit board.

In an embodiment, the IED comprises an enclosure for accommodating removably the at least one printed circuit, the memory module is fixed to the enclosure, and the connector is arranged such that the memory module is connected removably to the at least one printed circuit board when the at least one printed circuit board is accommodated in the enclosure.

In an embodiment, the IED comprises a backplane, the at least one printed circuit board is connected to the backplane, and the connector is connected to the backplane. For example, the connector is fixed to the backplane or to the at least one printed circuit board.

### BRIEF DESCRIPTION OF THE DRAWINGS

The present invention will be explained in more detail, by way of example, with reference to the drawings in which:
Fig. 1 shows a block diagram illustrating schematically an IED having a backplane and several printed circuit boards removed from an enclosure, a memory module being fixed to the enclosure and a connector being fixed to the backplane,
Fig. 2 shows a block diagram illustrating schematically an IED having the backplane and the printed circuit boards accommodated in the enclosure, and the memory module being connected via the connector to the backplane,
Fig. 3 shows a block diagram illustrating schematically an IED having a backplane and several printed circuit boards removed from an enclosure, a memory module being connected to one of the printed circuit boards via a connector fixed to this printed circuit board, and
Fig. 4 shows a block diagram illustrating schematically an IED having the backplane and the printed circuit boards accommodated in the enclosure, and the memory module being connected to one of the printed circuit boards via a connector fixed to this printed circuit board.

### DETAILED DESCRIPTION OF PREFERRED EMBODIMENTS

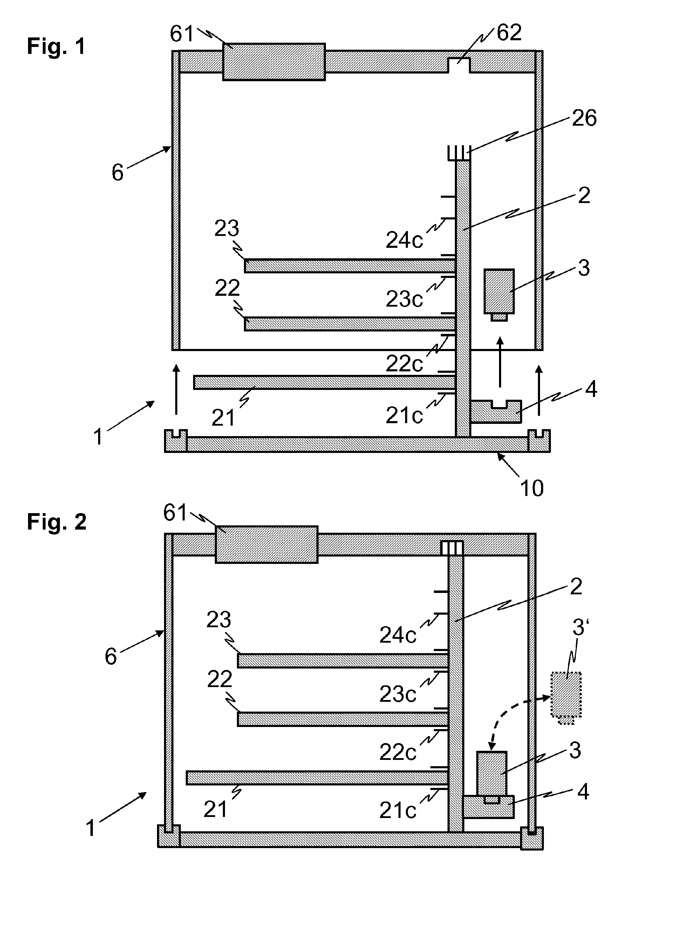

In Figs. 1, 2, 3, 4 reference numeral 1 refers to an Intelligent Electronic Device (IED) for Substation Automation (e.g. utility substation automation) or process control (e.g. industrial process automation), e.g. in an electric power system.

As is illustrated in Figs. 1, 2, 3, 4, IED 1 comprises a backplane 2 which interconnects various printed circuit boards 21, 22, 23 via a backplane bus. The printed circuit boards 21, 22, 23 are connected removably to the backplane bus through connector slots 21c, 22c, 23c, 24c. For example, printed circuit board 21 is a CPU board comprising a CPU.

Reference numeral 62 refers to a connector slot for connecting removably the backplane 2 via connection elements 26 to peripheral devices, specifically to current and voltage (CT/VT) sensors and digital input/output channels, which are connected to IED 1 via input/output connectors 61.

Preferably, connector slot 62 and input/output connectors 61 are integrated in an enclosure 6 (housing) of the IED 1.

In a preferred embodiment, backplane 2 and printed circuit boards 21, 22, 23 are connected to a human machine interface (HMI) 10, e.g. a display panel and/or other visual indicator elements such as LEDS, and data entry elements such as a keyboard and/or keys. In the following sections the arrangement of backplane 2, printed circuit boards 21, 22, 23 and optionally HMI 10 are referred to collectively as IED module.

In case of a replacement, the IED module can be removed from enclosure 6 without the need for unwiring any cables connected to the input/output connectors 61. Alternatively, the hard-wiring can be replaced by a process bus connection as stipulated in EP-A 1976177.

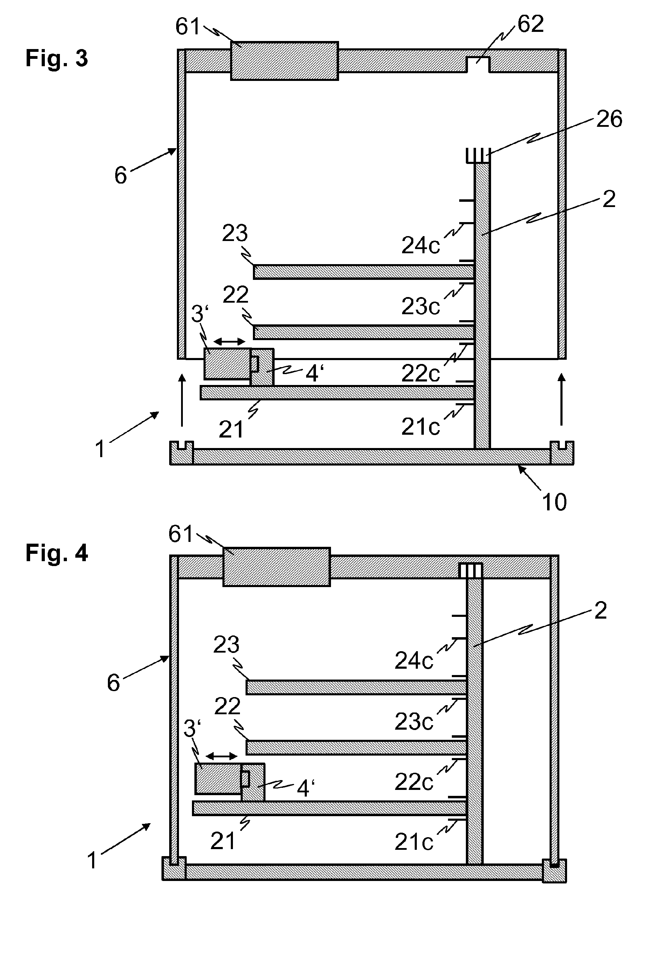

Figs. 1 and 3 illustrate embodiments of IED 1 in a state where the IED module is separated from enclosure 6, e.g. for testing, maintenance or assembly purposes; in this separated state, backplane 2 and printed circuit boards 21, 22, 23 are disconnected from connector slot 62 of enclosure 6, and thus from input/output connectors 61.
Figs. 2 and 4 illustrate embodiments of IED 1 in a state where the IED module is inserted into and accommodated in enclosure 6; in this assembled and operational state, backplane 2 and printed circuit boards 21, 22, 23 are connected to connector slot 62 of enclosure 6, and thus to input/output connectors 61.

In Figs. 1 and 2, reference numerals 3, 3' refer to a memory module, e.g. a flash memory module. Memory module 3, 3' is dedicated to storing configuration information associated with IED 1. For example, the configuration information includes a name assigned to IED 1, one or more addressing elements assigned to IED 1, and/or configuration data related to a HMI 10. Table 1 shows an excerpt of an exemplary IED Configuration Description (ICD) file in Substation Configuration Language (SCL) for an IED 1 named "BAY1" and reported as Logical Device 0 "LD0", depicting its address details for GOOSE communication over the subnetwork "UPLINK".

**Table 1**

| |
|---|
| - <Communication> |
| - <SubNetwork name=**"UPLINK"** type=**"8-MMS"** desc=**"IEC61850-8-1 addresses"**> |
| - <ConnectedAP iedName="**BAY1"** apName=**"LD0">** |
| - <Address> |
| <P type=**"IP">192.168.2.10**</P> |
| <P type=**"IP-SUBNET">255.255.255.0**</P> |
| <P type=**"IP-GATEWAY">192.168.2.1**</P> |
| <P type=**"OSI-PSEL"**>**00000001**</P> |
| <P type=**"OSI-SSEL"**>**0001**</P> |
| <P type=**"OSI-TSEL"**>**0001**</P> |
| </Address> |
| </ConnectedAP> |
| </SubNetwork> |
| </Communication> |

In Figs. 1, 2, 3, 4 reference numerals 4, 4' refer to a connector for connecting and disconnecting the memory module 3, 3' to and from one or more of the printed circuit boards 21, 22, 23 (preferably, at least to the CPU board 21), e.g. via the backplane bus of backplane 2. The connector 4, 4' is configured to attach and detach mechanically and repeatedly the memory module 3, 3' to and from the IED module, and thereby connect and disconnect electrically the memory module 3, 3' to and from the printed circuit board(s) 21, 22, 23. For example, connector 4, 4' is implemented as a USB connector, or another connector configured to couple and decouple mechanically and electronically the memory module 3, 3' to and from the printed circuit board(s) 21, 22, 23 or backplane 2, respectively, e.g. via an USB port and the backplane bus of backplane 2.

In the embodiment of Fig. 1, memory module 3 is fixed to the enclosure 6 of IED 1 and connector 4 is fixed to backplane 2. In the embodiment of Fig. 1, memory module 3 and connector 4 are arranged in such a way that contact elements of connector 4 engage with corresponding contact elements of memory module 3 upon insertion of the IED module into enclosure 6. Thus, as illustrated in Fig. 2, when the IED module is inserted into enclosure 6, the memory module 3 is being connected mechanically and electrically to the IED module, i.e. to backplane 2 and the printed circuit board(s) 21, 22, 23. Consequently, in the embodiment of Fig. 1, upon device failure, it is possible to remove the IED module from enclosure 6, replace one or more components or the complete IED module, and reinsert the replacement IED module into enclosure 6 whereby memory module 3 is (re-)connected to the IED module and the configuration information is retrieved automatically, e.g. by the CPU board 21, from memory module 3 at start up time of the replacement IED module. The CPU is configured to read the configuration information from (re-)connected memory module 3.

In Fig. 2, reference numeral 3' refers to a (replaceable) memory module which is not fixed to enclosure 6 but attached and connected manually to connector 4 and thus to backplane 2, before the IED module is inserted in enclosure 6.

In the embodiment of Figs. 3 and 4, connector 4' is fixed directly to a printed circuit board, e.g. CPU board 21. As illustrated in Figs. 3 and 4, (replaceable) memory module 3' is attached and connected manually to connector 4', before the IED module is inserted in enclosure 6.

Consequently, upon device failure, it is possible in the embodiments relying on a replaceable memory module 3' to remove the IED module from enclosure 6, unplug the memory module 3' from the faulty IED module, replace one or more components or the complete IED module, reconnect the memory module 3' to the replacement IED module, and reinsert the replacement IED module into enclosure 6 whereby the configuration information is retrieved automatically, e.g. by the CPU board 21, from memory module 3' at start up time of the replacement IED module. The CPU is configured to read the configuration information from memory module 3'.

The embodiments relying on a replaceable memory module 3' have the advantage that the memory module 3' can be connected first to the IED module, e.g. for testing and configuration purposes, and only later, e.g. at installation time, insert the IED module with memory module 3' into enclosure 6.

In an alternative embodiment, not covered by the scope of the present claims, a specific configuration device ("IED configuration server") or a software application providing this service is connected onto the station bus (e.g. on a gateway) and announces its service through a protocol, e.g. "Universal Plug and Play". The configuration caches the configuration information of all IEDs in a substation. Upon failure of an IED, a spare device (e.g. a CPU board 21 or an entire IED module) is inserted in enclosure 6 and is set up with a location identifier, or a device name (e.g. IED_Control_Bay_1) assigned during engineering, for example. If enclosure 6 itself has to be replaced, memory module 3, 3' is removed and plugged into the replacement enclosure. Subsequently, the IED's firmware attempts to locate the configuration service on the network, submits the device identifier, and in turn receives the cached configuration information. In an embodiment, the configuration server maintains a connection to the configuration database (the database into which the system engineering tools store its information). Upon changes to the IED's configuration, the configuration server pushes out new device configurations to the IEDs supporting the update mechanism. Thus, configuration updates are push to connected IEDs in a defined process.

## Claims

1. An Intelligent Electronic Device (1) for Substation Automation or process control, the Intelligent Electronic Device (1) comprising at least one printed circuit board (21, 22, 23),
**characterized in that** the Intelligent Electronic Device (1) comprises a dedicated memory module (3) for storing configuration information associated with the Intelligent Electronic Device (1), and
a connector (4, 4') for connecting and disconnecting the memory module (3) to and from the at least one printed circuit board (21, 22, 23).

2. The Intelligent Electronic Device (1) according to claim 1, **characterized in that** the connector (4, 4') is configured to attach and detach and thereby connect and disconnect electrically the memory module (3) to and from the at least one printed circuit board (21, 22, 23).

3. The Intelligent Electronic Device (1) according to one of claims 1 or 2, **characterized in that** the Intelligent Electronic Device (1) comprises an enclosure (6) for accommodating removably the at least one printed circuit board (21, 22, 23), **in that** the memory module (3) is fixed to the enclosure (6), and **in that** the connector (4) is arranged such that the memory module (3) is connected removably to the at least one printed circuit board (21, 22, 23) when the at least one printed circuit board (21, 22, 23) is accommodated in the enclosure (6).

4. The Intelligent Electronic Device (1) according to one of claims 1 to 3, **characterized in that** the Intelligent Electronic Device (1) comprises a backplane (2), **in that** the at least one printed circuit board (21, 22, 23) is connected to the backplane (2), and **in that** the connector (4, 4') is connected to the backplane (2).

5. The Intelligent Electronic Device (1) according to claim 4, **characterized in that** the connector (4') is fixed to the backplane (2).

6. The Intelligent Electronic Device (1) according to one of claims 1 to 4, **characterized in that** the connector (4') is fixed to the at least one printed circuit board (21, 22, 23).

7. The Intelligent Electronic Device (1) according to one of claims 1 to 6, **characterized in that** the at least one printed circuit board (21) comprises a Central Processing Unit configured to read the configuration information from the memory module (3).

8. The Intelligent Electronic Device (1) according to one of claims 1 to 7, **characterized in that** the memory module (3) comprises flash memory.

9. The Intelligent Electronic Device (1) according to one of claims 1 to 8, **characterized in that** the configuration information includes at least one of a name assigned to the Intelligent Electronic Device (1), one or more addressing elements assigned to the Intelligent Electronic Device (1), and configuration data related to a human machine interface of the Intelligent Electronic Device (1).
